**Europäisches Patentamt**

**European Patent Office**

**Office européen des brevets**

(19)

(11) **EP 1 549 110 A1**

## (12) EUROPEAN PATENT APPLICATION
published in accordance with Art. 158(3) EPC

(43) Date of publication:
**29.06.2005 Bulletin 2005/26**

(21) Application number: **03791212.8**

(22) Date of filing: **13.08.2003**

(51) Int Cl.⁷: **H05B 33/22**, H05B 33/14

(86) International application number:
**PCT/JP2003/010299**

(87) International publication number:
**WO 2004/021746 (11.03.2004 Gazette 2004/11)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **30.08.2002 JP 2002255661**

(71) Applicant: **Pioneer Corporation
Tokyo 153-8654 (JP)**

(72) Inventors:
  • **NAGAYAMA, K.,Corp. Res. & Dev. Lab.,Pioneer
    Corp.
    Saitama 350-2288 (JP)**

  • **MIYAGUCHI, S.,Corp. Res. & Dev. Lab.,Pioneer
    Corp.
    Saitama 350-2288 (JP)**
  • **SHIRATORI, M.,Corp. Res. & Dev. Lab.,Pioneer
    Corp.
    Saitama 350-2288 (JP)**

(74) Representative: **Betten & Resch
Patentanwälte,
Theatinerstrasse 8
80333 München (DE)**

## (54) ORGANIC EL ELEMENT

(57)    In order to prevent shorts between anode and cathode by dielectric breakdown in an organic EL element, the organic EL layer includes a leak prevention layer that takes on a high resistance when its temperature is increased.

Fig. 1

EP 1 549 110 A1

**Description**

TECHNICAL FIELD

The present invention relates to organic electroluminescent elements.

BACKGROUND ART

Organic EL (electroluminescent) elements having a structure in which an organic functional layer is sandwiched between an anode and a cathode are known as one type of light-emitting thin film elements.

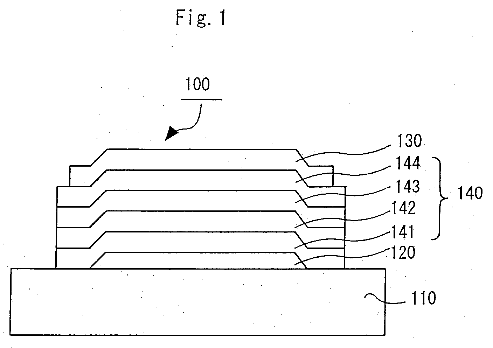

Fig. 1 is a cross-sectional view showing an example of a conventional organic EL element 100. The organic EL element 100 includes a substrate 110, an anode 120 formed on the substrate 110, an organic functional layer 140 made of a plurality of layers laminated on the anode 120, and a cathode 130 formed on the organic functional layer 140.

The organic functional layer 140 is a functional layer including at least a light-emitting layer. In Fig. 1, the organic functional layer 140 includes a hole injection layer 141, a hole transport layer 142, a light-emitting layer 143, and an electron injection layer 144, layered in this order on top of the anode 120.

When a voltage is applied between the anode 120 and the cathode 130, holes are injected into the light-emitting layer 143 via the hole transport layer 142 from the anode 120 or the hole injection layer 141, while at the same time electrons are injected into the light-emitting layer 143 from the cathode 130 or the electron injection layer 144. Inside the light-emitting layer 143, the holes and electrons recombine, forming excitons. Within an extremely short time, the excitons fall to a lower energy level, and some emit the energy difference between the lower energy level and the excited state as light. The light given off within this light-emitting layer 143 is emitted to the side of the substrate 110 or to the side of the cathode 130. Thus, the organic EL element 100 functions as a light-emitting element.

However, when there are defect locations in this conventional organic EL element, such as pinholes or partially thinner film thickness, then the resistance at those defect locations becomes lower than at other portions, and current (electrons or holes) concentrates at those defect locations. This results in the problem that the buildup of Joule heat and the increase in the strength of the electric field due to such concentrations causes dielectric breakdown at the defect locations, and ultimately leads to shorts between the anode and the cathode.

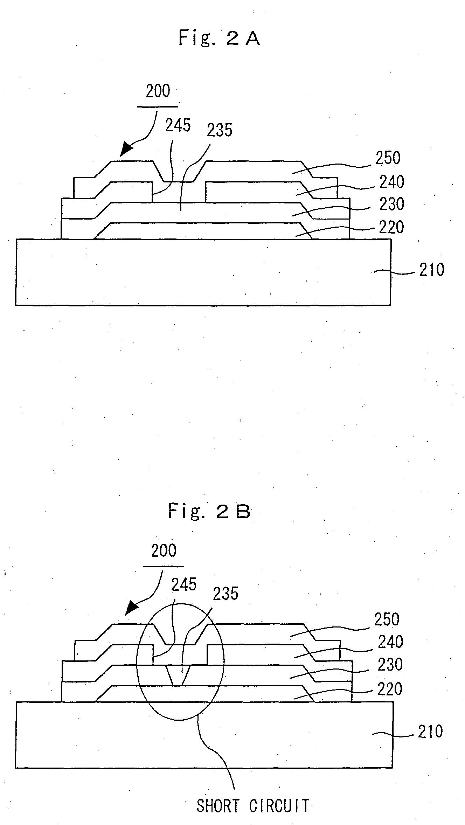

Figs. 2A and 2B illustrate this dielectric breakdown due to defects. This organic EL element 200 is fabricated by forming an anode 220 on a substrate 210, then forming an organic functional layer 230 and an organic functional layer 240, followed by forming a cathode 250. In the organic EL element 200 in Fig. 2A, a pinhole 245, which is a defect, has developed in the organic functional layer 240 during the film formation process, and this pinhole 245 is filled by the cathode 250.

When a voltage is applied to this organic EL element 200 having such a defect, current concentrates at a portion 235 within the organic functional layer 230 located directly below the pinhole 245 resulting in a large electric field. When this state continues, dielectric breakdown occurs in the portion 235 within the organic functional layer 220, as shown in Fig. 2B, the anode 220 and the cathode 250 are shorted, and the organic EL element 200 cannot function as a light-emitting element anymore. When an organic EL element having such a defect is used for a display panel or the like, the display quality of the display panel is severely damaged, and its value as a product is diminished.

The above-described defect tends to occur in particular when organic functional layers are formed by a vapor deposition process. Ordinarily, vapor deposition processes have poor step coverage (i.e. ability to cover steps), so that film defects are easily incurred by scratches in the substrate or foreign matter on the substrate.

One of the issues addressed by the present invention is the problem that shorts occur between anode and cathode due to dielectric breakdown, as described above.

DISCLOSURE OF THE INVENTION

An organic EL element according to one aspect of the present invention includes an anode, a cathode, and a light-emitting organic EL layer sandwiched between the anode and the cathode, and includes at least a leak prevention layer that takes on a high resistance when its temperature is increased.

BRIEF DESCRIPTION OF THE DRAWINGS

Fig. 1 is a diagram showing an example of an organic EL element.
Figs. 2A and 2B are diagrams illustrate a problem of organic EL elements.
Fig. 3 is a diagram showing an embodiment of the organic EL element according to the present invention.

Figs. 4A and 4B are diagrammatic views illustrating the effect of the leak prevention layer.

Figs. 5A and 5B are graphs illustrating the resistance of the leak prevention layer as a function of temperature.

Figs. 6A and 6B are diagrams showing the after-treatment for improving the step coverage of a leak prevention layer formed by vapor deposition or the like.

Fig. 7 is a diagram showing a modified embodiment of the organic EL element according to the present invention.

Fig. 8 is a diagram showing another modified embodiment of the organic EL element according to the present invention.

Fig. 9 is a graph showing the relation between the heating temperature and the specific resistance of a polyaniline film.

Fig. 10 is a diagram showing the inverse voltage characteristics of organic EL elements.

EMBODIMENTS OF THE INVENTION

The following is a detailed description of embodiments of an organic EL element according to the present invention.

An organic EL element according to the present invention is provided with a light-emitting organic EL layer, sandwiched between an anode and a cathode. This organic EL layer includes at least a leak prevention layer that takes on a high resistance when its temperature is raised. The following is a more detailed explanation of an organic EL element according to this embodiment, with reference to the accompanying drawings.

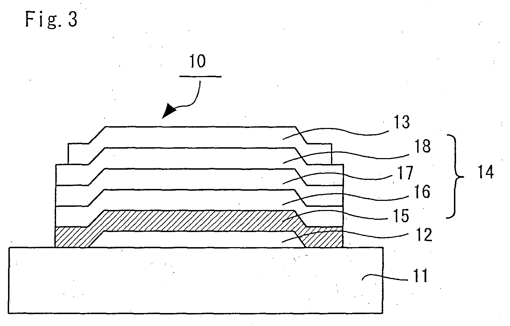

Fig. 3 is a cross-sectional view showing an organic EL element 10 as an embodiment of the present invention. This organic EL element 10 includes a substrate 11, an anode formed on the substrate 11, an organic functional layer 14 made of a plurality of layers layered on the anode 12, and a cathode 13 formed on the organic functional layer 14.

The organic functional layer 14 includes, in order from the side of the anode 13, a hole injection layer 15, a hole transport layer 16, a light-emitting layer 17, and an electron injection layer 18. When a voltage is applied, the hole injection layer 15 injects holes via the hole transport layer 16 into the light-emitting layer 17. And when a voltage is applied, the electron injection layer 18 injects electrons into the light-emitting layer 17. Within the light-emitting layer 17, the holes and electron recombine, forming excitons. Within an extremely short time, the excitons fall to a lower energy level, and some emit the energy difference between the lower energy level and the excited state as light. The light given off within this light-emitting layer 17 is emitted to the side of the substrate 11 or to the side of the cathode 13. Thus, the organic EL element 10 functions as a light-emitting element.

Within an ordinary working temperature region, the hole injection layer 15 functions as a hole injection layer injecting holes via the hole transport layer 16 into the light-emitting layer 17. On the other hand, in a temperature region that is higher than the ordinary working temperature region, it functions as a leak prevention layer that suppresses excessive currents. The hole injection layer 15 is made of a material whose specific resistance increases at least in a high temperature region that exceeds the maximum working temperature of the product (maximum operating temperature or maximum storage temperature), thus taking on a high resistance. Consequently, the hole injection layer 15 takes on a high resistance as a result of the generation of Joule heat due to current concentration caused by defects. Thus, the current is curbed, and the element can be protected from such damage as dielectric breakdown.

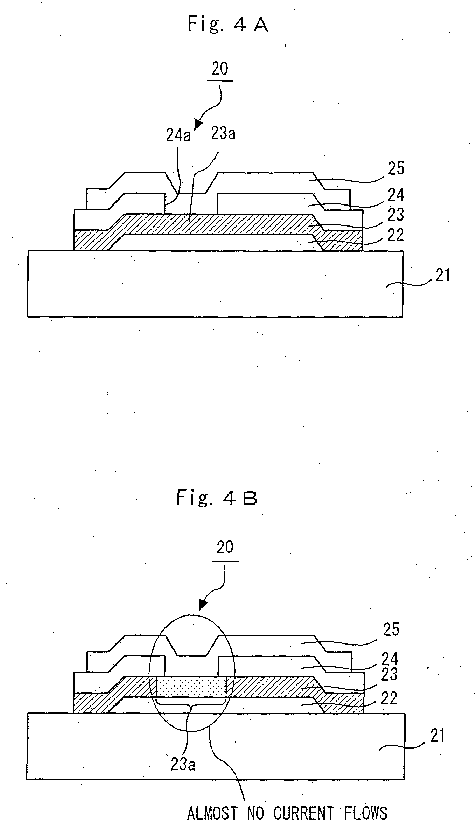

Figs. 4A and 4B are diagrammatic views illustrating the effect of the leak prevention layer. Here, to simplify the explanations, the organic functional layer is shown as being made only of two layers, namely the leak prevention layer and the other layers.

In Fig. 4A, the organic EL element 20 is fabricated by forming an anode 22 on a substrate 21, then forming a leak prevention layer 23 and an organic functional layer 24, followed by forming a cathode 25. Here, the leak prevention layer 23 is made of a material whose specific resistance increases at least in a high temperature region that exceeds the maximum working temperature of the product (maximum operating temperature or maximum storage temperature), thus taking on a high resistance. Furthermore, in this organic EL element 20, there is a pinhole 24a, which is a defect, formed during the film formation process in the organic functional layer 24, and this pinhole 24a is filled up by the cathode 25.

When voltage is applied to the organic EL element 20 having such a defect, current concentrates at a portion 23a within the leak prevention layer 23 that is located directly below the pinhole 24a, resulting in a large electric field. This current concentration causes a large Joule heat, which increases the temperature of the leak prevention layer beyond the maximum working temperature. As shown in Fig. 4B, this temperature increase causes the specific resistance of the leak prevention layer 23 to rise, so that the leak prevention layer 23 takes on a high resistance. Consequently, the current flowing in the leak prevention layer 23 is decreased, lessening the heat generation and the electric field in the leak prevention layer (thermal repair). Thus, by providing a layer functioning as a leak prevention layer as one layer of the organic functional layer, current concentrations at one location within the organic functional layer can be prevented, and breakdown of the organic EL element 20 can be prevented.

In Fig. 3, the hole injection layer 15 was configured as a leak prevention layer, but the leak prevention layer may be provided at any position of the organic functional layer. As mentioned before, the leak prevention layer does not only prevent current concentrations, but may also perform a part of the functions of the organic EL element during ordinary operation, such as injection or transport of carriers (electrons or holes). Consequently, in order to increase the element efficiency of the overall organic EL element, it is necessary to appropriately set the ionization potential, the carrier mobility etc. in accordance with the location where it is placed. For example, a leak prevention layer that is arranged closer to the cathode than the light-emitting layer needs to have high electron transport abilities, and a leak prevention layer that is arranged closer to the anode than the light-emitting layer needs to have high hole transport abilities.

The layers other than the leak prevention layer are made of a low-molecular weight material, and if the leak prevention layer is made by a wet film formation process, such as spin-coating or printing, or by a film formation process causing considerable damage to the substrate, such as sputtering, then it is preferable that the leak prevention layer is formed first. Ordinarily, organic materials of low molecular weight have a low resistance to solvents and a low heat resistance. Consequently, when the organic functional layers other than the leak prevention layer, which are made of organic materials of low molecular weight, are formed, and then the leak prevention layer is formed by one of the above-mentioned processes, then there is the possibility that the organic functional layers other than the leak prevention layer are damaged.

More concretely, in the case of an organic EL element in which the anode is arranged on the substrate, it is preferable that a leak prevention layer with hole transport capability is formed directly on the anode. And in the case of an organic EL element in which the cathode is arranged on the substrate, it is preferable that a leak prevention layer with electron transport capability is formed directly on the cathode.

It is preferable that the leak prevention layer is increased takes on a high resistance at temperatures above 120°C. The working temperature range of ordinary organic EL elements is up to about 100°C, so that it becomes possible to inhibit failure of the element due to current concentrations by letting it take on a high resistance at temperatures higher than that.

Furthermore, it is even more preferable that the leak prevention layer takes on a high resistance at temperatures above 200°C. Even though the working temperature range of organic EL elements is up to about 100°C, the organic EL element may become 120 to 200°C during use, due to Joule heat generated by the current flowing through the organic EL element and heat generation from locations outside the organic EL element, such as driving circuitry. Thus, in order to not hinder the driving of the organic EL element during ordinary operation, it is better not to let it take on a high resistance up to 200°C.

It is preferable that the leak prevention layer takes on a high resistance at temperatures less than 400°C, and it is even more preferable that it takes on a high resistance at temperatures less than 300°C. When examining portions where a short has developed between anode and cathode in conventional organic EL elements, it can be seen how the Al used for the cathode has melted, so that it seems that defect portions occur where the temperature has risen locally and temporarily to the melting point of Al (about 660°C). Ordinarily, in high temperature regions, such as above 500°C, the leak prevention layer itself is decomposed, and its weight is reduced fast, so that it loses the capability to prevent shorts. Consequently, it is not preferable that the taking on of a high resistance by the leak prevention layer occurs at temperatures at which it is not helpful in order to prevent shorts. Ordinarily, it is effective that it takes on a high resistance in a temperature region of about 300 to 400°C.

In conclusion, it is preferable that the leak prevention layer takes on a high resistance at temperatures of 120 to 400°C, and it is even more preferable that it takes on a high resistance at temperatures of 200 to 300°C.

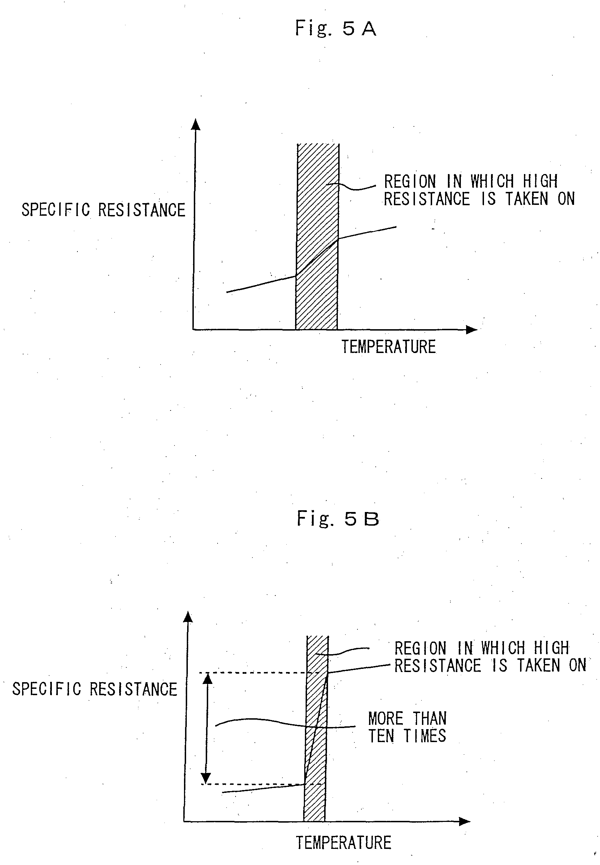

Figs. 5A and 5B are graphs illustrating the resistance of the leak prevention layer as a function of temperature. Here, it is preferable that the resistance of the leak prevention layer exhibits a steep rate of change in the region of temperatures at which it takes on a high resistance. When the change in the region of temperatures at which it takes on a high resistance (region in which high resistance is taken on) is smooth as in Fig. 5A, then the lessening of the current at the defect portions proceeds slowly, so that the influence of the Joule heat extends to the areas around the defect portions. Ideally, the leak prevention layer acts as a fuse in the defect portions, and it is desirable that the resistance of the leak prevention layer increases sharply in the region of temperatures at which a high resistance is taken on, as in Fig. 5B.

Here, that the leak prevention layer takes on a high resistance means that Joule heat due to current concentrations increases the resistance of the leak prevention layer considerably to an extent at which no shorts occur between the electrodes. When a defect portion has assumed a high temperature due to current concentration, the resistance of the leak prevention layer alone needs to be increased to a resistance equivalent to that of the entire organic functional layer of a normal portion, in order to lessen the current concentration. In other words, it needs to be increased to a resistance equivalent to the anode-cathode resistance during normal operation. That is, the following expression has to be satisfied:

(resistance of leak prevention layer when taking on a

high resistance) ≥ (resistance of organic functional layer

at ordinary temperature)

To what extent the resistance of the leak prevention layer should change in the process of shifting from ordinary temperatures to high resistances cannot be said unconditionally, because it depends on the structure of the element, but in general, it is preferable that the resistance is increased by at least one order of magnitude, or becomes insulating (specific resistance of at least $10^{11}\Omega\cdot$cm) when taking on a high resistance.

The leak prevention layer prevents breakdown of the organic EL element caused by defect portions formed unintentionally in other layers constituting the organic functional layer. Consequently, there should not be any defects in the leak prevention layer itself. However, when there are uneven portions due to scratches or foreign matter on the substrate, then common defects occur easily in the layers constituting the organic functional layer, so that there is the possibility that defects occur in the leak prevention layer itself. If a large number of defects occur in the leak prevention layer, then it may not be capable of preventing shorts even when taking on a high resistance due to Joule heat.

Considering the above, it is preferable that the leak prevention layer has a step coverage that is as least as good as that of the other organic functional layers, and that it has few pinholes. In order to form a film with good step coverage and few pinholes, it is preferable to form the leak prevention layer by a wet film formation process, such as spin-coating or printing, or by a vapor-phase film formation process with good wraparound, such as CVD.

Furthermore, if the leak prevention layer is fabricated by a film formation process with high directionality and poor step coverage, such as vapor deposition, then it is preferable to provide the film with good step coverage by after-processing.

Here, "spin-coating" refers to methods of dropping a flowable material onto a rotating layering surface, and applying that material uniformly on the layering surface by centrifugal force. Furthermore, "printing" refers to methods such as flexography.

Furthermore, "CVD (chemical vapor deposition)" refers to methods in which a vapor of the molecules of a reaction system or a mixed vapor of such molecules and an inactive carrier is flowed onto a heated substrate, and the reaction product from a reaction such as hydrolysis, autolysis, photolysis, oxidation-reduction, or substitution is deposited on the substrate.

Furthermore, "vapor deposition" refers to methods in which small pieces of metal or non-metal are evaporated by heating in a high vacuum, and quasi-adhered as a thin film on a primer surface, such as glass, a quartz plate, a cleaved crystal or the like.

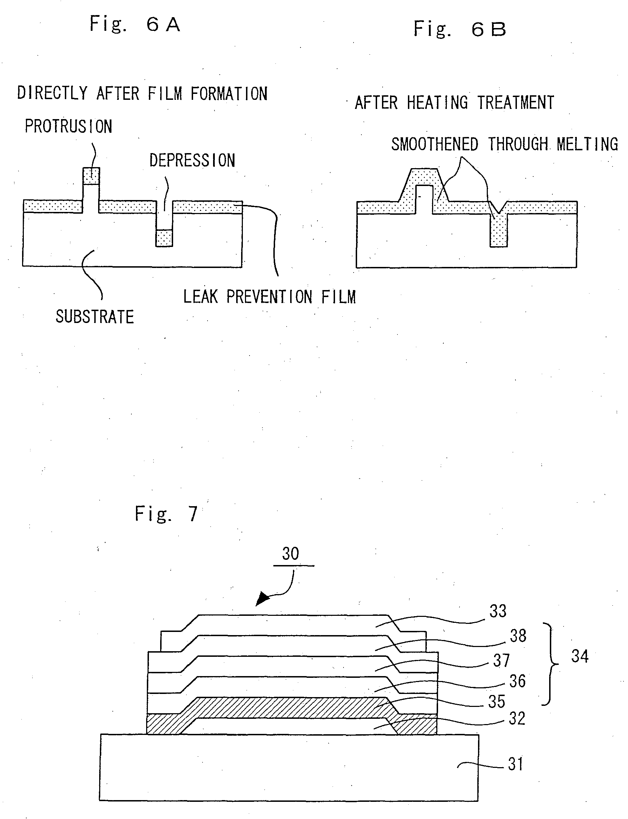

Figs. 6A and 6B show an example of an after-treatment process for improving the step coverage of a leak prevention layer formed by vapor deposition. As shown in Fig. 6A, when a film formation process with poor step coverage, such as vapor deposition, is used, then the leak prevention layer is formed on the upper surface of protrusions and the bottom surface of depressions, but the leak prevention layer is difficult to form at the lateral surfaces of the protrusions and depressions. For this reason, the layer below the leak prevention layer is exposed, and it is difficult to completely cover the layer below it completely with the leak prevention layer.

In order to correct this deficiency, the leak prevention layer is heated in an after-treatment to a temperature close to the glass transition point or melting point of the material constituting the leak prevention layer. Due to this heating, the leak prevention layer is melted and shifted, covering the exposed layer below it. Thus, the surface of the leak prevention layer is smoothened, pinholes are eliminated, and it becomes possible to improve its step coverage.

Here, if the leak prevention layer is thick, then there are few pinholes and the step coverage is good, so that it is possible to attain a film with few defects. Also, the resistance of the leak prevention layer in the film thickness direction is proportional to the product of specific resistance and film thickness of the leak prevention layer, so that if the leak prevention layer is thick, the effect of taking on a high resistance due to high temperatures at defect portions is even more pronounced, which is preferable.

However, if the leak prevention layer is thick and its resistance in film thickness direction becomes large, then the driving voltage of the element at ordinary portions is increased. Moreover, if the leak prevention layer is formed such that it is common to and there is full contact between adjacent pixels, then, if the film thickness of the leak prevention layer is too thick, the resistance in horizontal direction (sheet resistance) of the leak prevention layer becomes small, and there is the possibility that adjacent pixels becomes electrically shorted. The sheet resistance of the leak prevention layer is proportional to (specific resistance/film thickness).

If the leak prevention layer is thin, then the resistance of the leak prevention layer in film thickness direction becomes small, and the driving voltage of the element at ordinary portions is decreased. However, if the leak prevention layer is thin, there are more pinholes, and the step coverage becomes poor, so that the film will contain many defects.

Furthermore, the resistance of the leak prevention layer in the film thickness direction becomes small, so that there is the possibility that the effect of taking on a high resistance due to high temperatures at defect portions becomes small.

Considering the above, as a lower limit for the thickness of the leak prevention layer it is preferable that the resistance in thickness direction of the leak prevention layer after it has taken on a high resistance at high temperatures is set to be larger than the resistance in thickness direction of the organic functional layer in the regular portions (outside the leak prevention layer). Furthermore, it is preferable that the leak prevention layer is so thick that no defects occur in it. As a range fulfilling these conditions, it is preferable that the film thickness of the leak prevention layer is for example about 100Å.

Furthermore, if the leak prevention layer is formed such that it is common to and there is full contact between adjacent pixels, then it is preferable that adjacent pixels are not shorted and no cross-talk occurs. The range fulfilling this condition depends on the size of the gap between adjacent pixels, but to be specific, the sheet resistance of the leak prevention layer is preferably at least 1 MΩ·cm, more preferably at least 10 MΩ·cm, and even more preferably at least 100 MΩ·cm.

As a material for the leak prevention layer fulfilling these conditions, it is possible to use a polymer material whose conductivity has been increased by doping it with an acid. More specifically, it is possible to use a conductive polymer, such as polyaniline, polypyrrole, polythiophene or polyfuran. These polymers may be doped with an acid in order to elevate their conductivity. When these polymers are heated to a high temperature, the doped acid is de-doped, and their resistance increases, so that their conductivity decreases. These materials ordinarily can be formed into a film by spin-coating or printing.

As acids with which these polymers can be doped, it is possible to use inorganic acids, such as hydrochloric acid, sulfuric acid or nitric acid, or acetic acid, formic acid or oxalic acid.

It is also possible to use an organic semiconductor that takes on a high resistance by thermally decomposing as the material for the leak prevention layer. More specifically, it is possible to use an organic semiconductor such as a TCNQ (7,7,8,8-tetracyanoquinomethane) complex. When this type of organic semiconductor is heated to a high temperature, it thermally decomposes and takes on a high resistance. With these materials, it is possible to form films by vapor deposition. After the film has been formed by vapor deposition, it is possible to decrease defects such as pinholes and to improve its step coverage by subjecting it to a heating treatment, as described above.

(Modified Embodiment)

A modified embodiment of the present invention will now be described.

In the above-described embodiment, a structure was shown in which the anode is formed on the substrate, but the present invention is not limited thereto, and it can also be applied to structures in which the cathode is formed on the substrate. An example of this is depicted as a modified embodiment in Fig. 7.

In the organic EL element in Fig. 7, a cathode 32 is formed on a substrate 31, and layered on top thereof is an organic functional layer 34 including, in that order, an electron injection layer 35, a light-emitting layer 36, a hole transport layer 37 and a hole injection layer 38. An anode 33 is formed on the hole injection layer 38.

In the organic EL element in Fig. 7, the electron injection layer 35 functions as an electron injection layer for injecting electrons into the light-emitting layer 36 in an ordinary working temperature region, and functions as a leak prevention layer suppressing excessive currents. The electron injection layer 35 is made of a material whose specific resistance increases at least in a high temperature region that exceeds the maximum working temperature of the product (maximum operating temperature or maximum storage temperature), thus taking on a high resistance. Consequently, the electron injection layer 35 takes on a high resistance by the generation of Joule heat due to current concentration caused by defects. Thus, the current is curbed, and the element can be protected from such damage as dielectric breakdown.

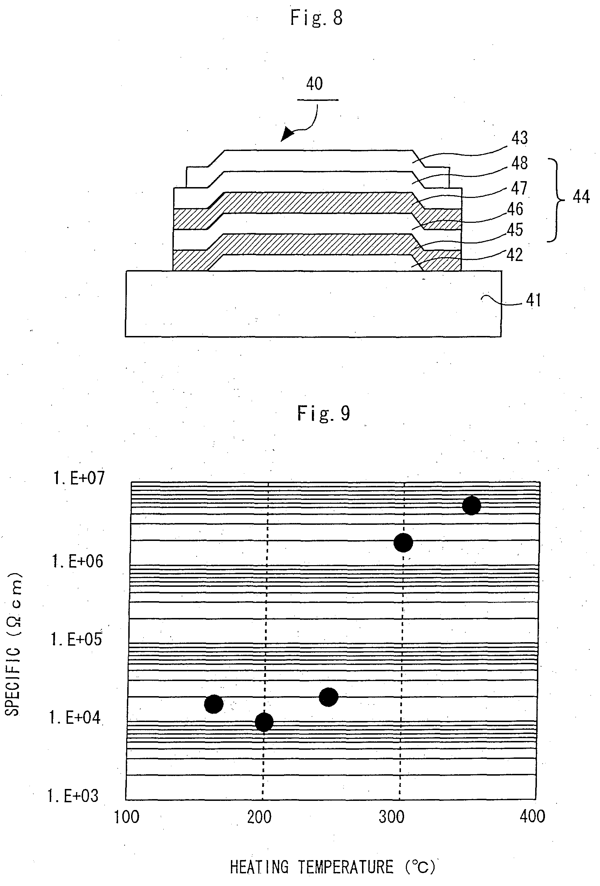

Fig. 8 shows another modified embodiment of the present invention. In the organic EL element in Fig. 8, a cathode 42 is formed on a substrate 41, and layered on top thereof is an organic functional layer 44 including, in that order, an electron injection layer 45, a light-emitting layer 46, a hole transport layer 47 and a hole injection layer 48. An anode 43 is formed on the hole injection layer 48.

In the organic EL element in Fig. 8, the electron injection layer 45 functions as an electron injection layer for injecting electrons into the light-emitting layer 46 in an ordinary working temperature region, and also functions as a leak prevention layer suppressing excessive currents. Furthermore, the hole injection layer 48 functions as a hole injection layer for injecting holes into the light-emitting layer 46 in an ordinary working temperature region, and also functions as a leak prevention layer suppressing excessive currents. The electron injection layer 45 and the hole injection layer 48 are made of materials whose specific resistance increases at least in a high temperature region that exceeds the maximum working temperature of the product (maximum operating temperature or maximum storage temperature), thus taking on a high resistance. Consequently, the electron injection layer 45 and the hole injection layer 48 take on a high resistance by the generation of Joule heat due to current concentration caused by defects.

Therefore, the current is curbed, and the element can be protected from such damage as dielectric breakdown. It is thus also possible to provide the organic functional layer with two or more leak prevention layers.

The following is an explanation of a manufacturing method of the embodiments of the organic EL element according to the present invention. However, it should be noted that the present invention is not limited to the examples described below.

(Example 1)

In Example 1, an organic EL element was fabricated with the following procedure.

(1) Anode Formation

An ITO film of 1500Å thickness was formed by sputtering on a glass substrate. Then, the photoresist AZ6112 (by Tokyo Ohka Kogyo, Co., Ltd.) was patterned on the ITO film. The resulting substrate was immersed in a mixture of a ferric chloride aqueous solution and hydrochloric acid, and the portion of the ITO not covered by the resist was etched away. After that, the glass substrate was immersed in acetone to remove the resist, thus obtaining a predetermined ITO electrode pattern.

(2) Formation of Leak Prevention Layer

A coating liquid of a polyaniline derivative doped with acid dissolved in an organic solvent was spin-coated onto the glass substrate of (1). The coating liquid adhering to terminal portions outside the display portion of the substrate was removed by wiping it off, and then the substrate was heated with a hot plate to evaporate the solvent, thus obtaining a polyaniline film (leak prevention layer) of 450Å thickness.

(3) Formation of Other Organic Functional Layers and Cathode

A NPABP film of 250Å and an Alq3 film of 600Å thickness were formed by vapor deposition on the glass substrate of (2) as the organic functional films besides the leak prevention layer. Furthermore, an Al-Li alloy film of 1000Å thickness was formed by vapor deposition as the cathode, thus concluding the organic EL element. The size of the organic EL element defined by the intersection of anode and cathode was 2 mm $\times$ 2 mm.

(Comparative Example 1)

As Comparative Example 1, an organic EL element was prepared in the same manner as in Example 1, except that Step (2) of Example 1 was not performed (that is, no leak prevention layer was formed), and the film thickness of the NPABP in Step (3) was set to 700Å. The organic EL element of Example 1 and the organic EL element of Comparative Example 1 had the same total film thickness.

(Specific Resistance of the Polyaniline Derivative Film)

A polyaniline film was formed on glass substrates in the same manner as in Step (2) of Embodiment 1, thus preparing samples. These samples were heated for 5 min with a hot plate to various temperatures. The sheet resistance of the heated samples was measured by the two-terminal method, and their film thickness was measured with a Dektak stylus profilometer, and their respective specific resistance was determined from the measurement results.

Fig. 9 is a graph showing the relation between the heating temperature and the specific resistance of the polyaniline film. At 250 to 300°C, the specific resistance of the polyaniline derivative film increases roughly by a factor of 100. It seems that this is a result of the doped acid being de-doped due to heat, leading to a sharp increase in resistance. Thus, at a temperature region of 250 to 300°C, the resistance of this polyaniline film increases sharply to take on a high resistance, showing that the polyaniline film is suitable as a leak prevention layer.

(Inverse Properties of the Element)

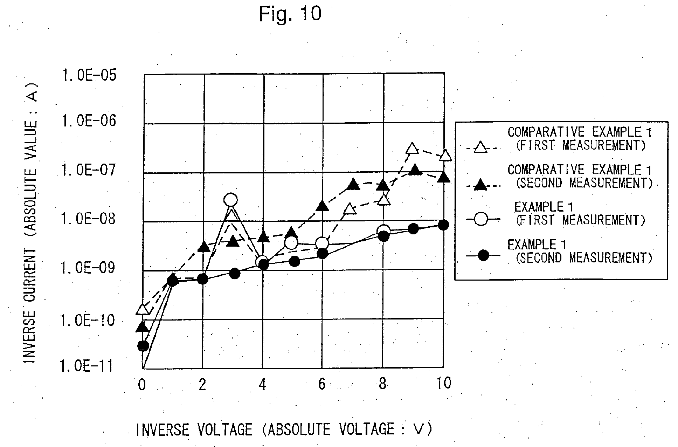

A reverse voltage (anode to minus and cathode to plus) was applied to the elements fabricated in Example 1 and Comparative Example 1, and the current flowing through the elements was measured. The measurement was carried out twice per sample. The measurement results are shown in Fig. 10.

In the element of Example 1, a rise in current can be observed that appears to be caused by shorts between anode and cathode near 3 V and 5 V at the first measurement, but the current immediately returns to normal values.

It seems that a large current temporarily flowed at defect portions, but the effect of the leak prevention layer lessened the current concentration. At the second measurement, no rise in current could be observed, and smooth characteristics with small current values are attained. It seems that this is because the defect portions that appeared when a voltage was applied for the first time were repaired by the leak prevention layer.

On the other hand, in the element of Comparative Example 1, there is a rise in current at both the first and the second measurement that appears to stem from shorts between anode and cathode, and there is no sign that the defects are repaired. Thus, it was found that the breakdown of the element due to current concentrations is prevented by providing a leak prevention layer.

(Example 2)

An organic EL display panel was manufactured with the following procedure.

(1) Anode Formation

An ITO film of 1500Å thickness was formed by sputtering on a glass substrate. Then, the photoresist AZ6112 (by Tokyo Ohka Kogyo, Co., Ltd.) was patterned on the ITO film. The resulting substrate was immersed in a mixture of a ferric chloride aqueous solution and hydrochloric acid, and the portion of the ITO not covered by the resist was etched away. After that, the glass substrate was immersed in acetone, to remove the resist, thus obtaining a stripe-shaped electrode pattern made of 256 lines.

(2) Formation of Leak Prevention Layer

A coating liquid of a polyaniline derivative doped with acid dissolved in an organic solvent was spin-coated in the glass substrate of (1). The coating liquid adhering to terminal portions outside the display portion of the substrate was removed by wiping it off, and then the substrate was heated with a hot plate to evaporate the solvent, thus obtaining a polyaniline film (leak prevention layer) of 450Å thickness.

(3) Formation of Other Organic Functional Layers and Cathode

A NPABP film of 250Å and an Alq3 film of 600Å thickness were formed by vapor deposition on the glass substrate of (2) as the organic functional films besides the leak prevention layer. Furthermore, an Al-Li alloy film of 1000Å thickness was formed by vapor deposition as the cathode, using a mask made of a striped pattern with 64 stripes. The size of one dot defined by the intersection of anodes and cathodes was 0.3 mm $\times$ 0.3 mm, and there were 256 $\times$ 64 dots.

(4) Sealing

Under a dry nitrogen atmosphere, a sealing plate having a desiccant fixed to its depression portions was laminated with an adhesive against the substrate of Step (3), thus forming a passively driven organic EL display panel.

(Comparative Example 2)

As Comparative Example 2, an organic EL panel with 256 $\times$ 64 dots was prepared in the same manner as in Example 2, except that Step (2) of Example 2 was not performed (that is, no leak prevention layer was formed), and the film thickness of the NPABP was set to 700Å. The organic EL elements of Example 2 and the organic EL elements of Comparative Example 1 had the same total film thickness.

(High-Speed Continuous Driving Test)

The panels fabricated in Example 2 and Comparative Example 2 were connected to a predetermined driving circuit, and after operating them continuously for 500 hours under a 85°C atmosphere, the number of dots that have become defective as a result of shorts between anode and cathode were counted. The results were as follows:

· Panel of Example 2: Number of Defect Dots: 0
· Panel of Comparative Example 2: Number of Defect Dots: 16

Consequently, it was confirmed that in the panel of Example 2, which has a leak prevention layer, there were fewer defects due to shorts than in the panel of Comparative Example 2, which does not have a leak prevention layer.

As described above, an organic EL element according to an embodiment of the present invention includes an anode, a cathode, and a light-emitting organic EL layer sandwiched between the anode and the cathode, the organic EL layer having at least a leak prevention layer that takes on a high resistance when its temperature is increased. Consequently, even when there is an excessive current caused by defects in the organic functional layer, the leak prevention layer takes on a high resistance as a result of the heat generated by the excessive current, and the current is curbed, so that element breakdown caused by defects of the organic EL element can be prevented before it occurs.

Furthermore, the step coverage of the leak prevention layer is made at least equivalent to that of the other layers, so that the leak prevention layer can cover defect portions in the organic functional layer, and the effect of the present invention can be improved even further.

**Claims**

1. An organic EL element comprising an anode, a cathode, and a light-emitting organic EL layer sandwiched between said anode and said cathode;
   wherein said organic EL layer comprises a leak prevention layer that takes on a high resistance when its temperature is increased.

2. The organic EL element according to claim 1, wherein said leak prevention layer has hole transport abilities, and transports holes from the anode side to the cathode side.

3. The organic EL element according to claim 1 or 2, wherein said leak prevention layer has electron transport abilities, and transports electrons from said cathode side to said anode side.

4. The organic EL element according to claim 1 or 2, wherein said leak prevention layer is arranged in contact with said anode.

5. The organic EL element according to claim 1 or 3, wherein said leak prevention layer is arranged in contact with said cathode.

6. The organic EL element according to any of claims 1 to 5, wherein said leak prevention layer takes on a high resistance at temperatures of at least 120°C.

7. The organic EL element according to claim 6, wherein said leak prevention layer takes on a high resistance at temperatures of 120 to 400°C.

8. The organic EL element according to claim 7, wherein said leak prevention layer takes on a high resistance at temperatures of 200 to 300°C.

9. The organic EL element according to any of claims 1 to 8, wherein, when taking on a high resistance, the specific resistance of said leak prevention layer increases at least by a factor of 10.

10. The organic EL element according to any of claims 1 to 8, wherein, when taking on a high resistance, the specific resistance of said leak prevention layer becomes at least $10^{11} \Omega \cdot cm$.

11. The organic EL element according to any of claims 1 to 10, wherein said leak prevention layer is made of a conductive polymer that is doped with an acid.

12. The organic EL element according to any of claims 1 to 11, wherein said leak prevention layer is made by a wet film formation process or a vapor-phase film formation process.

Fig. 1

Fig. 2 A

200

245    235

250
240
230
220

210

Fig. 2 B

200

245    235

250
240
230
220

210

SHORT CIRCUIT

Fig. 3

Fig. 4 A

20

24a  23a

25

24

23

22

21

Fig. 4 B

20

25

24
23

22

21

23a

ALMOST NO CURRENT FLOWS

Fig. 5 A

SPECIFIC RESISTANCE

TEMPERATURE

REGION IN WHICH HIGH
RESISTANCE IS TAKEN ON

Fig. 5 B

SPECIFIC RESISTANCE

TEMPERATURE

REGION IN WHICH HIGH
RESISTANCE IS TAKEN ON

MORE THAN
TEN TIMES

Fig. 6 A

DIRECTLY AFTER FILM FORMATION

PROTRUSION

DEPRESSION

SUBSTRATE

LEAK PREVENTION FILM

Fig. 6 B

AFTER HEATING TREATMENT

SMOOTHENED THROUGH MELTING

Fig. 7

30

33
38
37
36
35
32

34

31

Fig. 8

40

43
48
47
46
45
42
44

41

Fig. 9

HEATING TEMPERATURE (℃)

SPECIFIC (Ω cm)

1.E+07

1.E+06

1.E+05

1.E+04

1.E+03

100   200   300   400

Fig. 10

## INTERNATIONAL SEARCH REPORT

| | International application No. |
|---|---|
| | PCT/JP03/10299 |

**A. CLASSIFICATION OF SUBJECT MATTER**
Int.Cl$^7$ H05B33/22, H05B33/14

According to International Patent Classification (IPC) or to both national classification and IPC

**B. FIELDS SEARCHED**

Minimum documentation searched (classification system followed by classification symbols)
Int.Cl$^7$ H05B33/00-33/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2000-164357 A (Agilent Technologies Inc.), 16 June, 2000 (16.06.00), Full text; all drawings & EP 1003229 A | 1-12 |
| A | JP 2002-175888 A (TDK Corp.), 21 June, 2002 (21.06.02), (Family: none) | 1 |
| A | JP 2001-160492 A (Japan Science and Technology Corp.), 12 June, 2001 (12.06.01), (Family: none) | 1 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 04 September, 2003 (04.09.03) | 24 September, 2003 (24.09.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

**INTERNATIONAL SEARCH REPORT**

| International application No. |
| --- |
| PCT/JP03/10299 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2001-319788 A  (Matsushita Electric Industrial Co., Ltd.), 16 November, 2001 (16.11.01), (Family: none) | 1 |
| A | JP 4-297076 A  (Toshiba Corp.), 21 October, 1992 (21.10.92), Page 4, left column, lines 41 to 50 (Family: none) | 1 |
| A | JP 2000-348868 A  (Dainippon Printing Co., Ltd.), 15 December, 2000 (15.12.00), (Family: none) | 1 |

Form PCT/ISA/210 (continuation of second sheet) (July 1998)